# EUROPÄISCHE PATENTSCHRIFT

(11) **EP 1 095 411 B1**
(45) Veröffentlichungstag und Bekanntmachung des Hinweises auf die Patenterteilung: **14.01.2009**
(21) Anmeldenummer: 99942731.3
(22) Anmeldetag: 30.06.1999
(51) Int. Cl.: H01L 33/00, H01L 31/0203

(54) **STRAHLUNGAUSSENDENDES UND/ODER -EMPFANGENDES BAUELEMENT**
RADIATION-EMITTING AND/OR -RECEIVING COMPONENT
COMPOSANT EMETTANT ET/OU RECEVANT UN RAYONNEMENT

(30) Priorität: 30.06.1998 DE 19829197
(43) Veröffentlichungstag der Anmeldung: 02.05.2001
(73) Patentinhaber: OSRAM Opto Semiconductors GmbH, 93055 Regensburg (DE)
(72) Erfinder: WAITL, Günter, D-93049 Regensburg (DE); BRUNNER, Herbert, D-93047 Regensburg (DE)
(74) Vertreter: Epping - Hermann - Fischer
(86) Internationale Anmeldenummer: PCT/DE1999/001912
(87) Internationale Veröffentlichungsnummer: WO 2000/002262

(56) Entgegenhaltungen:
- DE-A- 19 536 454
- MOELLMER F ET AL: "SIEMENS-SMT-TOP-LED - LEDS FOR SURFACE MOUNTING. ÖPART 1: CHARACTERISTICS AND SPECIAL FEATURES" COMPONENTS,DE,SIEMENS AKTIENGESELLSCHAFT. MUNCHEN, Bd. 26, Nr. 4 / 05, Seite 147-149 XP000266913 ISSN: 0945-1137 in der Anmeldung erwähnt

## Beschreibung

Die Erfindung bezieht sich auf ein strahlungaussendendes und/oder -empfangendes Bauelement gemäß dem Oberbegriff des Patentanspruches 1. Die Erfindung bezieht sich insbesondere auf derartige Halbleiter-Leuchtdioden(LED)-Bauelemente.

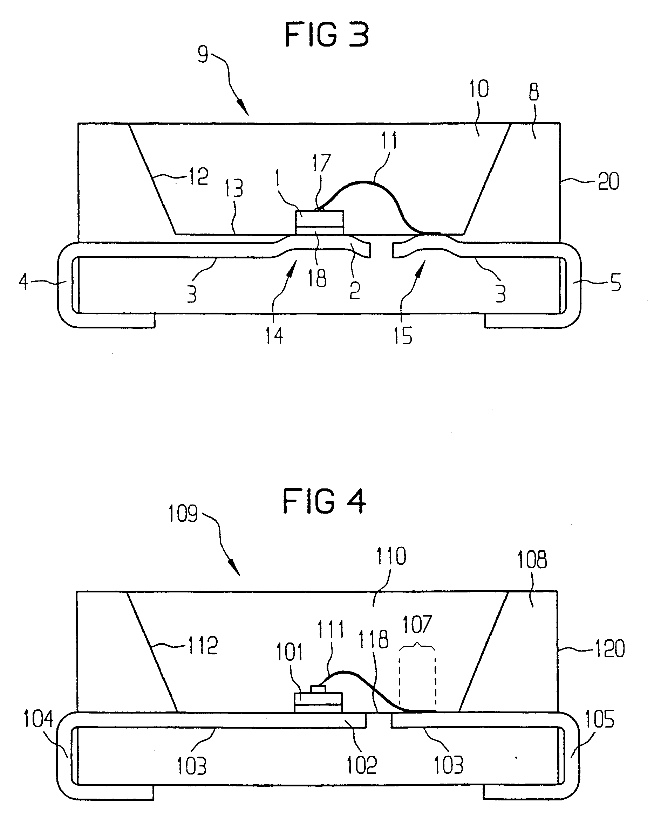

Ein derartiges strahlungaussendendes und/oder -empfangendes Bauelement ist beispielsweise aus der Veröffentlichung "Siemens SMT-TOPLED für die Oberflächenmontage", Siemens Components 26 (1991) Heft 4, Seiten 147 bis 149 bekannt. Bei dieser in Figur 4 schematisch dargestellten bekannten oberflächenmontierbaren Leuchtdiode (LED), ist ein strahlungaussendender Halbleiterchip 101 auf einem ebenen Chipträgerteil 102 eines ebenen Leiterrahmens 103 aus Metall befestigt. Der Leiterrahmen 103 setzt sich zusammen aus dem Chipträgerteil 102 mit einem ersten externen elektrischen Anschlussteil 104 und einem elektrisch isoliert von diesem angeordneten zweiten externen elektrischen Anschlussteil 105 mit einem Bondbereich 107 zum Bonden eines elektrischen Anschlussdrahtes 111 für den Halbleiterchip 101. Der Chipträgerteil 102 mit dem Halbleiterchip 101, und Teilbereiche der beiden externen elektrischen Anschlussteile 104,105 sind von einer Kunststoffumhüllung 120 umgeben, die sich aus einem strahlungsundurchlässigen Kunststoff-Grundkörper 108 mit einer Reflektor-Wanne 109 und einem diese ausfüllenden strahlungsdurchlässigen Kunststoff-Fensterteil 110 zusammensetzt. Der Kunststoff-Grundkörper 108 besteht aus einem Thermoplast mit einem hohen diffusen Reflexionsgrad von etwa 90%.

Die Reflektor-Wanne 109 weist eine parallel zu einer Montageoberfläche des Chipträgerteiles 102 liegende Bodenfläche 113 und eine dazu in einem stumpfen Winkel zur Bodenfläche 113 schräg stehende Seitenwandung 112 auf, so dass sie als Reflektor für die von dem Halbleiterchip 101 ausgesandte Strahlung wirkt. Die Bodenfläche 113 liegt in derselben Ebene wie die dem Halbleiterchip 101 zugewandte Oberfläche des ebenen Leiterrahmens 103, so dass der Boden des Reflektors zu einem großen Teil von der Leiterrahmenoberfläche gebildet ist. Der Chipträgerteil 102 und der zweite externe elektrische Anschlussteil 105 weisen hier folglich relativ große Grenzflächen zu dem strahlungsdurchlässigen Kunststoff-Fensterteil 110 auf.

Ein besonderes Problem dieser bekannten oberflächenmontierbaren Leuchtdiode besteht darin, daß an den Grenzflächen zwischen dem Leiterrahmen 103 und dem strahlungsdurchlässigen Fensterteil 110 bei starken Temperaturschwankungen im Bauelement oder in dessen Umgebung (z. B. in einem Automobil) aufgrund der unterschiedlichen thermischen Ausdehnungskoeffizienten des Leiterrahmens 103, der in der Regel aus einem Metall besteht, und des Kunststoff-Fensterteiles 110, in der Regel ein transparentes Epoxidharz, so große Scherkräfte auftreten, daß es häufig zu einer Ablösung des Fensterteiles 110 vom Leiterrahmen 103 kommt. Der dabei entstehende Spalt zwischen dem Leiterrahmen 103 und dem Kunststoff-Fensterteil 110 bewirkt, daß ein großer Teil der vom Halbleiterchip 101 ausgesandten elektromagnetischen Strahlung im Bauelement aufgrund von Mehrfachreflexionen absorbiert wird und damit verloren geht.
Darüber hinaus kann sich die Spaltbildung ausgehend von dem Spalt zwischen Leiterrahmen 103 und dem Kunststoff-Fensterteil 110 bis an die äußere Oberfläche der Kunststoffumhüllung 120 fortsetzen, was zu einem Eindringen von Feuchtigkeit bis zum Halbleiterchip 101 und zu dessen Schädigung führen kann.

Weiterhin ist aus der DE 195 36 454 A1 ein optoelektronisches Bauelement beschrieben, das prinzipiell den im oben genannten Dokument beschriebenen Aufbau aufweist. Zusätzlich bildet bei dem in dieser Offenlegungsschrift erläuterten Bauelement der Chipträgerteil eine Wanne, in der der Chip angeordnet ist und deren gesamte Innenfläche an das Fensterteil grenzt. Folglich können auch hier die oben geschilderten Probleme auftreten.

Der Erfindung liegt die Aufgabe zugrunde, ein strahlungaussendendes und/oder -empfangendes Bauelement der eingangs genannten Art zu entwickeln, bei dem die Gefahr einer Delamination an der Grenzfläche zwischen dem Fensterteil und dem Leiterrahmen verringert ist.

Diese Aufgabe wird mit einem strahlungaussendenden und/oder empfangenden Bauelement mit den Merkmalen des Anspruches 1 gelöst. Weiterbildungen des erfindungsgemäßen Bauelements sind Gegenstand der Unteransprüche 2 bis 4.

Gemäß der Erfindung weist der strahlungsundurchlässige Grundkörper in der Wanne von einer Bodenfläche der Wanne aus zum Chipträgerteil hin ein erstes Fenster auf, in dem der Chip mit dem Chipträgerteil verbunden ist. Weiterhin weist die Wanne von der Bodenfläche aus mindestens ein zweites Fenster zu dem bzw. zu den externen elektrischen Anschlussteilen hin auf, in denen die elektrischen Verbindungsleitung(en) zum Chip mit dem Leiterrahmen verbunden sind. Der besondere Vorteil dieser Weiterbildung liegt darin, dass der Grundkörper auf einfache Weise mit einem entsprechend geformten Spritzwerkzeug hergestellt werden kann.

In der Umhüllung sind der Chipträgerteil vorteilhafterweise bis auf denjenigen Oberflächenbereich, auf dem der Halbleiterchip befestigt ist, und die externen elektrischen Anschlussteile bis auf den- oder diejenigen Oberflächenbereich/e, auf dem bzw. auf denen eine oder mehrere elektrische Verbindungsleitungen zum Chip befestigt sind, vollständig von dem strahlungsundurchlässigen Grundkörper umschlossen.

Folglich ist bei einem Bauelement gemäß der Erfindung die Grenzfläche zwischen dem strahlungsdurchlässigen Fensterteil und dem Leiterrahmen auf ein Minimum reduziert. Demzufolge treten im Vergleich zum bekannten Bauelement bei Temperaturschwankungen deutlich geringere mechanischen Scherkräfte an dieser Grenzfläche auf, was zu einer Verminderung der Delaminationsgefahr führt.

Bei einer vorteilhaften Ausführungsform des strahlungaussendenden und/oder empfangenden Bauelements weisen der Chipträgerteil und die externen elektrischen Ahschlussteile in den Bereichen in denen der Chip bzw. die elektrischen Verbindungsleitung(en) befestigt sind, jeweils eine Kröpfung zur Wanne hin auf, derart, dass Teilbereiche der Oberflächen des Chipträgerteiles und der externen elektrischen Anschlussteile in der gleichen Ebene liegen wie eine Bodenfläche der Wanne oder in die Wanne hineinragen. Bei dieser Weiterbildung ist von Vorteil, daß zu deren Herstellung herkömmliche, für die Herstellung der oben beschriebenen bekannten SMT-TOPLED-Bauelemente verwendete Spritzwerkzeuge eingesetzt werden können, und daß für verschiedene Leiterrahmen-Designs z. B. für unterschiedliche Anordnungen des Halbleiterchips und der elektrischen Verbindungsleitungen immer dieselben Spritzwerkzeuge verwendet werden können.

Besonders vorteilhaft ist weiterhin, dass bei dem erfindungsgemäßen Bauelement die Größe der an das Fensterteil angrenzenden Metalloberfläche des Leiterrahmens auf ein Minimum reduziert ist, woraus sich eine verbesserte Gesamtreflektivität der Wanne ergibt. Das Metall des Leiterrahmens weist nämlich in der Regel einen geringeren Reflexionsgrad auf als das Material des Grundkörpers, wodurch die von dem Chip ausgesandte Strahlung dort stärker absorbiert wird. Bei den bekannten Bauelementen sind aus diesem Grund im Betrieb im Reflektor relativ große dunkle Bereiche erkennbar.

Vorteilhafterweise besteht der Grundkörper zur Erhöhung der Lichtausbeute aus dem Bauelement aus einem Material mit einem diffusen Reflexionsgrad von mehr als 80%, bevorzugt aus gefülltem Kunstharz.

Die Erfindung wird anhand von 2 Ausführungsbeispielen in Verbindung mit den Figuren 1 bis 4 näher erläutert. Es zeigen:
Figur 1 eine schematische Darstellung eines senkrechten Schnittes durch ein erster Ausführungsbeispiel,
Figur 2 eine schematische Darstellung einer Draufsicht auf das Ausführungsbeispiel von Figur 1,
Figur 3 eine schematische Darstellung eines senkrechten Schnittes durch ein zweites Ausführungsbeispiel,
Figur 4 eine schematische Darstellung eines strahlungaussendenden und/oder empfangenden Halbleiterbauelements gemäß dem Stand der Technik (weiter oben erläutert).

In den Figuren sind gleiche und gleichwirkende Bestandteile der verschiedenen Ausführungsbeispiele immer mit denselben Bezugszeichen versehen.

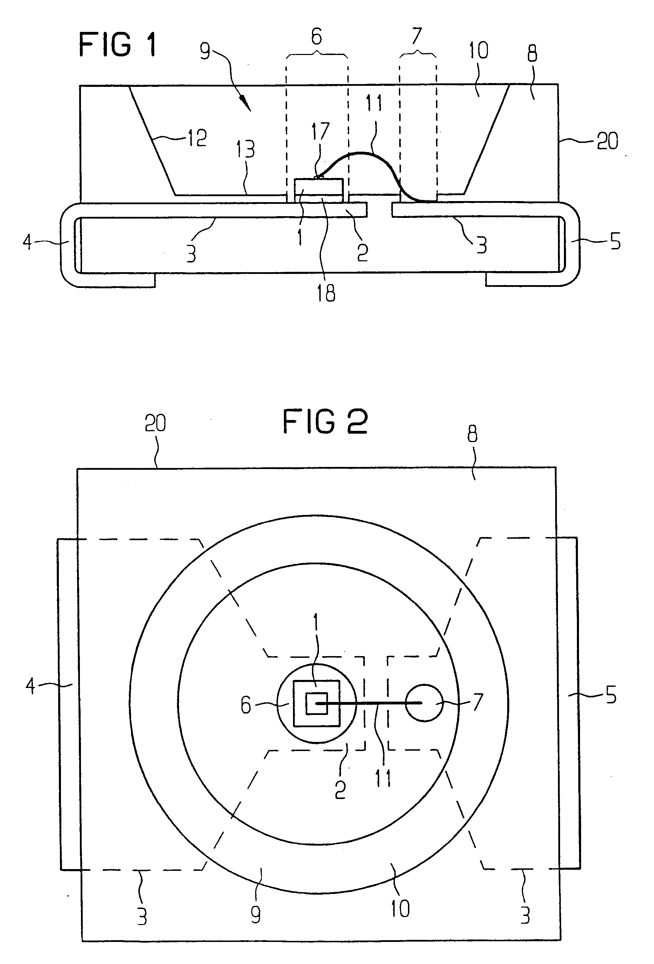

Bei dem Bauelement der Figuren 1 und 2 handelt es sich um ein Leuchtdioden-Bauelement in oberflächenmontierbarer Bauweise (Surface Mount Technology(SMT)). Dieses setzt sich zusammen aus einem elektrischen Leiterrahmen 3 (z. B. bestehend aus einem Metall) mit einem Chipträgerteil 2, einem ersten 4 und einem zweiten externen elektrischen Anschlussteil 5, einem auf dem Chipträgerteil 2 befestigten strahlungaussendenden Halbleiterchip 1 (LED-Chip), einem Verbindungsleiter 11 (Bonddraht) und einer quaderförmigen Kunststoffumhüllung 20.

Der Halbleiterchip 1 weist an seiner Vorderseite und an seiner Rückseite jeweils eine Kontaktmetallisierung 17,18 auf. Die Kontaktmetallisierung 18 an der Rückseite des Halbleiterchips 1 ist beispielsweise mittels eines metallischen Lotes oder eines elektrisch leitenden Klebstoffes mit dem Chipträgerteil 2 und die Kontaktmetallisierung 17 an der Vorderseite des Halbleiterchips 1 ist mittels eines Bonddrahtes 11, der z. B. aus Gold oder aus einem anderen geeigneten metallischen Werkstoff besteht, mit dem zweiten externen elektrischen Anschlussteil 5 elektrisch leitend verbunden.

Die Kunststoffumhüllung 20 besteht aus einem strahlungsundurchlässigen lichtreflektierenden Kunststoff-Grundkörper 8, aus dem die externen elektrischen Anschlussteile 4,5 herausragen, und einem strahlungsdurchlässigen Kunststoff-Fensterteil 10. Der Kunststoff-Grundkörper 8 weist eine Reflektor-Wanne 9 auf, in der der Halbleiterchip 1 angeordnet ist und die von dem Kunststoff-Fensterteil 10 ausgefüllt ist. Die Reflektor-Wanne 9 weist eine parallel zu einer Montageoberfläche des Chipträgerteiles 2 liegende Bodenfläche 13 und eine dazu in einem stumpfen Winkel zur Bodenfläche 13 schräg stehende Seitenwandung 12 auf, so daß sie als Reflektor für die von dem Halbleiterchip 1 ausgesandte Strahlung wirkt.

Der Kunststoff-Grundkörper 8 und der Kunststoff-Fensterteil 10 bestehen vorzugsweise aus einem mit reflexionssteigerndem Material gefüllten Kunstharz oder Thermoplast bzw. aus einem transparenten Kunstharz oder Polycarbonat. Als Füllstoff für Kunstharz eignen sich beispielsweise Metallpulver, Metalloxide, Metallcarbonate oder Metallsilikate.

Der Chipträgerteil 2 ist im wesentlichen bis auf denjenigen Oberflächenbereich 6 auf dem der Halbleiterchip 1 z. B. durch Chipbonden befestigt ist und die externen elektrischen Anschlussteile 4,5 sind bis auf den- oder diejenigen Oberflächenbereich/e 7, auf dem bzw. auf denen eine oder mehrere elektrische Verbindungsleitungen 11 zum Halbleiterchip 1 z. B. durch Drahtbonden befestigt werden, in der Kunststoffumhüllung 20 vollständig von dem strahlungsundurchlässigen Kunststoff-Grundkörper 8 umschlossen. Dies wird bei diesem besonders bevorzugten Ausführungsbeispiel dadurch erreicht, daß der strahlungsundurchlässige Kunststoff-Grundkörper 8 in der Wanne 9 ein erstes Fenster 6 zum Chipträgerteil 2 hin und mindestens ein zweites Fenster 7 zu dem bzw. zu den externen elektrischen Anschlußteilen 4,5 hin aufweist, in denen der Halbleiterchip 1 bzw. die elektrischen Verbindungsleitung(en) 11 zum Halbleiterchip 1 mit dem Leiterrahmen 3 verbunden sind.

Das in Figur 3 gezeigte Ausführungsbeispiel unterscheidet sich von dem der Figuren 1 und 2 im Wesentlichen darin, daß keine Fenster 6 und 7 zum Chipträgerteil 2 bzw. zu den Anschlußteilen 4,5 hin vorgesehen sind. An Stelle der Fenster 6,7 sind hier am Chipträgerteil 2 und an den externen elektrischen Anschlußteilen 4,5 in den Bereichen, in denen der Halbleiterchip 1 und die elektrische(n) Verbindungsleitung(en) 11 mit dem Leiterrahmen 3 verbunden sind, jeweils eine Kröpfung 14,15 zur Wanne 9 hin vorgesehen, derart, daß Teilbereiche der Oberflächen des Chipträgerteiles 2 und der externen elektrischen Anschlussteile 4,5 in der gleichen Ebene liegen wie eine Bodenfläche 13 der Wanne 9. Alternativ können die gekröpften Bereiche auch in die Wanne 9 hineinragen.

Die Erläuterung der Erfindung anhand dieser Ausführungsbeispiele ist selbstverständlicherweise nicht als Einschränkung der Erfindung auf diese zu verstehen. Vielmehr kann die Erfindung auch bei Photodioden-, Phototransistor-Bauelemente oder Polymer-Leuchtdioden-Bauelemente eingesetzt werden.

## Patentansprüche

1. Strahlungaussendendes und/oder -empfangendes Bauelement, bei dem mindestens ein eine elektromagnetische Strahlung aussendender und/oder empfangender Chip (1) auf mindestens einem Chipträgerteil (2) eines elektrischen Leiterrahmens (3) befestigt ist, der mindestens zwei externe elektrische Anschlußteile (4,5) aufweist, die elektrisch leitend mit dem Chip (1) verbunden sind, und
bei dem der Chipträgerteil (2) und Teilbereiche der externen elektrischen Anschlußteile (4,5) von einer Umhüllung (20) umschlossen sind, die einen strahlungsundurchlässigen Grundkörper (8) und einen strahlungsdurchlässigen Fensterteil (10) aufweist und aus der die externen elektrischen Anschlußteile (4,5) herausragen,
wobei der strahlungsundurchlässige Grundkörper (8) eine Wanne (9) aufweist, in der der Halbleiterchip (1) angeordnet ist und in oder über der sich der Fensterteil (10) befindet,
- von einer Bodenfläche der Wanne (9) aus, ein erstes Fenster (6) zum Chipträgerteil (2) hin ausgebildet ist, in dem der Chip (1) auf dem Chipträgerteil (2) befestigt ist, und
- von einer Bodenfläche der Wanne (9) aus mindestens ein zweites Fenster (7) zu mindestens einem externen elektrischen Anschlußteil (4,5) hin ausgebildet ist, in dem mindestens eine elektrische Verbindungsleitung (11) zum Chip (1) mit dem mindestens einen externen elektrischen Anschlußteil (4,5) verbunden ist, **dadurch gekennzeichnet, daß**
- auch im Bereich der Bodenfläche der Wanne (9) der Chipträgerteil (2) bis auf den durch das erste Fenster (6) freigelegten Oberflächenbereich, auf dem der Chip (1) befestigt ist, und die externen elektrischen Anschlußteile (4,5) bis auf den durch das zweite Fenster (7) freigelegten Oberflächenbereich, auf dem die mindestens eine elektrische Verbindungsleitung zum Chip befestigt ist, vollständig vom strahlungsundurchlässigen Grundkörper bedeckt sind.

2. Strahlungaussendendes und/oder -empfangendes Bauelement nach Anspruch 1, **dadurch gekennzeichnet, dass** zumindest der Chipträgerteil (2) oder zumindest einer der externen elektrischen Anschlußteile (4,5) im Bereich des jeweils zuge - hörigen Fensters (6,7), eine Kröpfung (14,15) zur Wanne (9) hin aufweist, derart, dass ein Teilbereich der Oberfläche des Chipträgerteiles (2) bzw. des externen elektrischen Anschlussteiles (4,5) in der gleichen Ebene liegt wie die Bodenfläche (13) der Wanne (9) oder in die Wanne (9) hineinragt.

3. Strahlungaussendendes und/oder -empfangendes Bauelement nach Anspruch 1 oder 2, **dadurch gekennzeichnet, daß** die Wanne (9) als Reflektor-Wanne ausgebildet ist.

4. Strahlungaussendendes und/oder -empfangendes Bauelement nach einem der Ansprüch 1 bis 3, **dadurch gekennzeichnet, daß** der Grundkörper (8) aus einem Material mit einem diffusen Reflexionsgrad von mehr als 80% besteht.

## Claims

1. Radiation transmitting and/or receiving component, in which at least one chip (1) which transmits and/or receives electromagnetic radiation is mounted on at least one chip mount part (2) of an electrical leadframe (3) which has at least two external electrical connecting parts (4, 5) which are electrically conductively connected to the chip (1), and
in which the chip mount part (2) and sub areas of the external electrical connecting parts (4, 5) are surrounded by a sheath (20) which has a base body (8) through which radiation cannot pass and a window part (10) through which radiation can pass, and from which the external electrical connecting parts (4, 5) project,
with the base body (8) through which radiation cannot pass having a well (9) in which the semiconductor chip (1) is arranged and in or above which the window part (10) is located,
- from a bottom surface of the well (9), a first window (6) is formed towards the chip mount part (2), in which window (6) the chip (1) is mounted on the chip mount part (2) and
- from a bottom surface of the well (9), at least one second window (7) is formed to at least one external electrical connecting part (4, 5) in which at least one electrical connection line (11) to the chip (1) is connected to the at least one external electrical connecting part (4, 5),
**characterized in that**
- in the area of the bottom surface of the well (9) as well, the chip mount part (2), except for the surface area which is exposed through the first window (6), and on which the chip (1) is mounted, and the external electrical connecting parts (4, 5), except for the surface area which is exposed through the second window (7) and on which the at least one electrical connection line to the chip is mounted, are completely covered by the base body through which radiation cannot pass.

2. Radiation transmitting and/or receiving component according to Claim 1, **characterized in that** at least the chip mount part (2) or at least one of the external electrical connecting parts (4, 5) has a crank (14, 15) towards the well (9) in the area of the respectively associated window (6, 7), such that a sub area of the surface of the chip mount part (2) or of the external electrical connecting part (4, 5) lies on the same plane as the bottom surface (13) of the well (9), or projects into the well (9).

3. Radiation transmitting and/or receiving component according to Claim 1 or 2, **characterized in that** the well (9) is in the form of a reflector well.

4. Radiation transmitting and/or receiving component according to one of Claims 1 to 3, **characterized in that** the base body (8) is composed of a material with a diffuse reflectance of more than 80%.

## Revendications

1. Composant émettant et/ou recevant du rayonnement, dans lequel au moins une puce (1) émettant et/ou recevant un rayonnement électromagnétique est fixée sur au moins une partie (2) de support de puce d'une grille (3) de connexion électrique qui a au moins deux parties (4,5) formant bornes électriques extérieures et reliées d'une manière conductrice de l'électricité à la puce (1) et,
dans lequel la partie (2) de support de puce et des sous-zones des parties (4,5) formant bornes électriques extérieures sont entourées d'un enrobage (20) qui a un corps (8) de base imperméable aux rayonnements et une partie (10) de fenêtre perméable aux rayonnements et duquel font saillies les parties (4,5) formant bornes électriques extérieures,
dans lequel le corps (8) de base imperméable aux rayonnements a un caisson (9) dans qui la puce (1) à semi-conducteur est disposé et dans ou sur qui se trouve la partie (10) de fenêtre,
- il est formé depuis la surface de fond du caisson (9) une première fenêtre (6) allant vers la partie (2) de support de puce, dans laquelle la puce (1) est fixée sur la partie (2) de support de puce, et
- il est formé depuis une surface de fond du caisson (9) au moins une deuxième fenêtre (7) allant vers au moins une partie (4,5) formant bornes électriques extérieures, dans laquelle au moins une première ligne (11) électrique de liaison à la puce (1) est reliée à la au moins une partie (4,5) formant bornes électriques extérieures,
**caractérisé en ce que,** également dans la zone de la surface de fond du caisson (9), la partie (2) de support de puce, à l'exception de la partie de surface qui est dégagée par la première fenêtre (6) et sur laquelle la puce (1) est fixée, et les parties (4,5) formant bornes électriques extérieures à l'exception de la partie de surface qui est dégagée par la deuxième fenêtre (7) et sur laquelle est fixée la au moins une ligne de liaison électrique vers la puce, sont recouvertes entièrement par le corps de base imperméable aux rayonnements.

2. Composant émettant et/ou recevant du rayonnement suivant la revendication 1,
**caractérisé en ce qu'**au moins la partie (2) de support de puce et au moins l'une des parties (4,5) formant bornes électriques extérieures a dans la région de la fenêtre (6,7) associée respectivement une partie (14,15) coudée allant vers le caisson (9) de façon à ce qu'une sous-zone de la surface de la partie (2) de support de puce ou de la partie (4,5) formant bornes électriques extérieures se trouve dans le même plan de la surface (13) de fond du caisson (9) ou pénètre dans le caisson (9).

3. Suivant les revendications 1 ou 2,
**caractérisé en ce que** le caisson est constitué en réflecteur-caisson.

4. Suivant l'une des revendications 1 à 3,
**caractérisé en ce que** le corps unique de base est en un matériau (1) d'un degré de réflexion diffus de plus de 80 %.
